# EUROPEAN PATENT APPLICATION

(11) **EP 3 557 827 A1**
(43) Date of publication of application: **23.10.2019**
(21) Application number: 17879955.7
(22) Date of filing: 11.12.2017
(51) Int. Cl.: H04L 25/49, H03M 7/14

(54) **ENCODING METHOD, DECODING METHOD, TRANSMISSION METHOD, DECODING DEVICE, ENCODING DEVICE, TRANSMISSION DEVICE**

(30) Priority: 16.12.2016 JP 2016244913
(71) Applicant: Panasonic Intellectual Property Management Co., Ltd., Osaka-shi, Osaka 540-6207 (JP)
(72) Inventor: MASUDA, Kohei, Osaka-shi, Osaka 540-6207 (JP); NAMBA, Akihiko, Osaka-shi, Osaka 540-6207 (JP)
(74) Representative: Vigand, Philippe
(86) International application number: PCT/JP2017/044289
(87) International publication number: WO 2018/110480

(57) **Abstract**

One of objects of the present disclosure would be to propose an encoding method, a decoding method, a transmission method, an encoding device, a decoding device, and a transmission device which enable reduction of degradation of waveforms caused by transmission. The encoding method includes an encoding process of encoding a bit sequence to be transmitted, into a symbol sequence. The symbol sequence includes a plurality of symbols each having a signal level to which any one of 2ⁿ different values is allocated. n is an integer equal to or larger than 1. The encoding process includes encoding the bit sequence to be transmitted into the symbol sequence so that the symbol sequence does not include one or more prohibited patterns. The one or more prohibited patterns include one or more specific patterns which are one or more of patterns representing transition of signal levels of three or more consecutive symbols. The one or more specific patterns include one or more patterns in which signal levels of any two adjacent symbols of the three or more consecutive symbols are different values.

## Description

### Technical Field

The present disclosure relates to encoding methods, decoding methods, transmission methods, decoding devices, encoding devices, and transmission devices. In particular, the present disclosure relates to an encoding method, a decoding method, a transmission method, a decoding device, an encoding device, and a transmission device, applying to a multi level transmission scheme using two or more levels. In more particular, the present disclosure relates to an encoding method, a decoding method, a transmission method, a decoding device, an encoding device, and a transmission device, applying to a multi level transmission scheme using four or more levels.

### Background Art

Patent Literature 1 discloses a picture data sending device and receiving device using multi level amplitude modulation. Patent Literature 1 discloses generating a multi level amplitude modulation signal by multi level amplitude modulation in which each symbol corresponds to N bits. Further, the multi level amplitude modulation is conducted to increase probability of appearance of a multi level signal level closest to an intermediate level having an intermediate value between a maximum level and a minimum level of the multi level signal level of the multi level amplitude modulation signal.

In Patent Literature 1, to reduce power consumption, the multi level amplitude modulation is performed so that the probability of appearance of the multi level signal level closest to the intermediate level becomes higher. However, there is no sufficient consideration for reduction of degradation of waveforms caused by transmission.

One of objects of the present disclosure would be to propose an encoding method, a decoding method, a transmission method, an encoding device, a decoding device, and a transmission device which enable reduction of degradation of waveforms caused by transmission.

### Citation List

### Patent Literature

Patent Literature 1: JP 5909692 B

### Summary of Invention

An encoding method according to one aspect of the present disclosure includes an encoding process of encoding a bit sequence to be transmitted, into a symbol sequence. The symbol sequence includes a plurality of symbols each having a signal level to which any one of 2ⁿ different values is allocated. n is an integer equal to or larger than 1. The encoding process includes encoding the bit sequence to be transmitted into the symbol sequence so that the symbol sequence does not include one or more prohibited patterns. The one or more prohibited patterns include one or more specific patterns which are one or more of patterns representing transition of signal levels of three or more consecutive symbols. The one or more specific patterns include one or more patterns in which signal levels of any two adjacent symbols of the three or more consecutive symbols are different values.

A decoding method according to another aspect of the present disclosure includes decoding a symbol sequence into a bit sequence to be transmitted, by a decoding process corresponding to the encoding process of the encoding method according the above aspect.

A transmission method according to another aspect of the present disclosure includes: encoding a bit sequence to be transmitted, into a symbol sequence by the encoding process of the encoding method according to the above aspect; sending a transmission signal representing the symbol sequence; receiving the transmission signal sent; and decoding the symbol sequence obtained from the transmission signal received, into the bit sequence to be transmitted, by the decoding process of the decoding method according to the above aspect.

An encoding device according to another aspect of the present disclosure is configured to perform an encoding process of encoding a bit sequence to be transmitted, into a symbol sequence. The symbol sequence includes a plurality of symbols each having a signal level to which any one of 2ⁿ different values is allocated. n is an integer equal to or larger than 1. The encoding process includes encoding the bit sequence to be transmitted into the symbol sequence so that the symbol sequence does not include one or more prohibited patterns. The one or more prohibited patterns include one or more specific patterns which are one or more of patterns representing transition of signal levels of three or more consecutive symbols. The one or more specific patterns include one or more patterns in which signal levels of any two adjacent symbols of the three or more consecutive symbols are different values.

A decoding device according to another aspect of the present disclosure is configured to decode a symbol sequence into a bit sequence to be transmitted, by a decoding process corresponding to the encoding process of the encoding device according to the above aspect.

A transmission device according to another aspect of the present disclosure includes: the encoding device according to the above aspect, for decoding a bit sequence to be transmitted, into a symbol sequence; a transmitter configured to send a transmission signal representing the symbol sequence from the encoding device; a receiver configured to receive the transmission signal sent from the transmitter; and the decoding device according to the above aspect, for decoding the symbol sequence obtained from the transmission signal received by the receiver, into the bit sequence to be transmitted.

### Brief Description of Drawings

FIG. 1 is a block diagram of a transmission device of Embodiment 1.
FIG. 2A and FIG. 2B are waveform charts of examples of prohibited patterns.
FIG. 3 is a diagram for illustration of an opening of an ideal eye pattern of a transmission signal.
FIG. 4 is a diagram for illustration of a signal waveform of a transmission signal in a situation an overshoot occurs.
FIG. 5A is a diagram for illustration of an example of an eye pattern of a two level signal waveform. FIG. 5B is a diagram for illustration of an example of an eye pattern of PAM4.
FIG. 6 is a flow chart of a transmission method implemented by the transmission device.
FIG. 7A is a diagram for illustration of an eye pattern of a transmission signal received by a receiver of the transmission device. FIG. 7B is a diagram for illustration of an eye pattern of a transmission signal received by a receiver of a transmission device of a comparative example.
FIG. 8 is a block diagram of a transmission device of Embodiment 2.
FIG. 9 is a block diagram of a transmission device of Embodiment 3.

### Description of Embodiments

### 1. Embodiment 1

### 1.1 Configuration

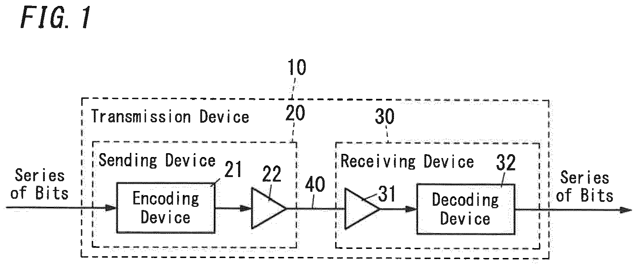

FIG. 1 is illustration for a transmission device 10 of one embodiment according to the present disclosure. The transmission device 10 is a device used for transmitting desired data (bit sequence) from an input device (e.g., a set top box) to an output device (e.g., a display).

As shown in FIG. 1, the transmission device 10 includes a sending device 20 and a receiving device 30. The sending device 20 and the receiving device 30 are interconnected by a transmission line 40. The sending device 20 is provided to the input device and the receiving device 30 is provided to the output device. In the present embodiment, the sending device 20 and the receiving device 30 are configured to communicate with each other by an optical transmission scheme. The transmission line 40 may be an optical cable (optical fiber cable), for example. In other words, the sending device 20 and the receiving device 30 constitute an optical transmission system.

The sending device 20 and the receiving device 30 are configured to perform transmission of signals by multi level pulse amplitude modulation. In the present embodiment, the sending device 20 and the receiving device 30 are configured to perform transmission of signals by four level pulse amplitude modulation (so-called, PAM4).

The sending device 20 includes: an encoding device 21 for encoding a bit sequence to be transmitted, into a symbol sequence; and a transmitter 22 for outputting a transmission signal to the transmission line 40 based on the symbol sequence generated by the encoding device 21.

The receiving device 30 includes: a receiver 31 for receiving a transmission signal from the transmitter 22 via the transmission line 40 and extracting the symbol sequence (a partial symbol sequence described later); and a decoding device 32 for decoding the symbol sequence extracted by the receiver 31, into a bit sequence.

The transmitter 22 is configured to output a symbol sequence (a partial symbol sequence) to the transmission line 40 by an optical transmission scheme. The transmitter 22 sequentially changes intensity of light outputted to the transmission line 40 in accordance with signal levels of a plurality of symbols constituting a symbol sequence, thereby outputs a transmission signal representing the symbol sequence to the transmission line 40. In this regard, the transmitter 22 functions as an electrical to optical converter. For example, the transmitter 22 includes a semiconductor laser for generating light rays (e.g., vertical cavity surface emitting laser: VCSEL) and a circuit for driving the VCSEL by electric signals.

The receiver 31 is configured to receive a transmission signal via the transmission line 40 by the optical transmission scheme, extract a symbol sequence (a partial symbol sequence) from the transmission signal received, and output it to the decoding device 32. For example, the receiver 31 determines signal levels of a plurality of symbols constituting the symbol sequence based on comparison between intensity of the transmission signal (intensity of light) and a threshold value. By doing so, the receiver 31 extracts the symbol sequence (the partial symbol sequence) from the transmission signal received, and outputs it to the decoding device 32. In this regard, the receiver 31 includes a photodetector for converting light into an electric signal, and a transmission impedance amplifier (TIA) for amplifying the electric signal converted by the photodetector.

The encoding device 21 is configured to perform an encoding method. The encoding method includes an encoding process of encoding a bit sequence to be transmitted, into a symbol sequence.

A symbol sequence includes a plurality of symbols each having a signal level to which any one of 2ⁿ different values is allocated. Therefore, each of the plurality of symbols has any one of 2ⁿ different signal levels. In the present embodiment, since transmission of signals may be done by use of four level amplitude modulation, n is 2. In summary, in the present embodiment, the symbol sequence is constituted by a plurality of symbols each having a signal level to which any one of four different values is allocated. Therefore, each of the plurality of symbols has any one of four different signal levels. In other words, in each of time periods individually corresponding to the plurality of symbols constituting the symbol sequence (encoding time periods), a signal level is set to any one of the four different values. The four different values are +3 (a first value), +1 (a second value), -1 (a third value), and -3 (a fourth value) in descending order, for example. Further, the encoding time period may range from 100 psec to 133 psec, for example.

The encoding device 21 performs the encoding process of encoding the bit sequence to be transmitted, into the symbol sequence so that the symbol sequence does not include one or more prohibited patterns. In detail, the encoding process includes an obtaining step and an encoding step.

The obtaining step is a step of obtaining a partial bit sequence constituted by m bits, from the bit sequence to be transmitted. m is a multiple of n. In the present embodiment, m is 8. In summary, due to the obtaining step, the partial bit sequence of 8 bits is obtained from the bit sequence to be transmitted.

The encoding step is a step of encoding the partial bit sequence into a partial symbol sequence which is constituted by 1+p symbols and does not include the one or more prohibited patterns, by use of a predetermined conversion table. In this regard, 1 is a value obtained by dividing m by n. p is an integer equal to or larger than 1. In the present embodiment, 1 is 4 and p is 1. In summary, the encoding step encodes the partial bit sequence constituted by 8 bits into the partial symbol sequence constituted by 5 symbols. In the encoding step, the partial bit sequence is converted into the partial symbol sequence directly by use of the predetermined conversion table. Therefore, the encoding process can be facilitated.

The one or more prohibited patterns include one or more specific patterns which are one or more of patterns representing transition of signal levels of three consecutive symbols.

The one or more specific patterns include one or more patterns in which signal levels of any two adjacent symbols of the three consecutive symbols are different values. Such patterns causing consecutive change in a signal level may be a cause of degradation of waveforms caused by transmission.

Especially, the one or more specific patterns may preferably include one or more patterns in which increase and decrease in a signal level occur. The reason is that such a pattern shows an extremum and thus a transmission signal with the pattern is considered to contain a high proportion of high frequency components. Further, the one or more specific patterns include one or more patterns in which a signal level is transitioned from a current value to a value which is neither a value larger than and next to the current value, nor a value smaller than and next to the current value. The reason is that such a pattern requires maximum change in a signal level and thus may be a cause of an overshoot or undershoot of a signal level. Additionally, it may be effective that the one or more specific patterns include one or more patterns in which a signal level transitions between a maximum value and a minimum value. The reason is that such a pattern requires maximum change in a signal level and thus may be a cause of an overshoot or undershoot of a signal level.

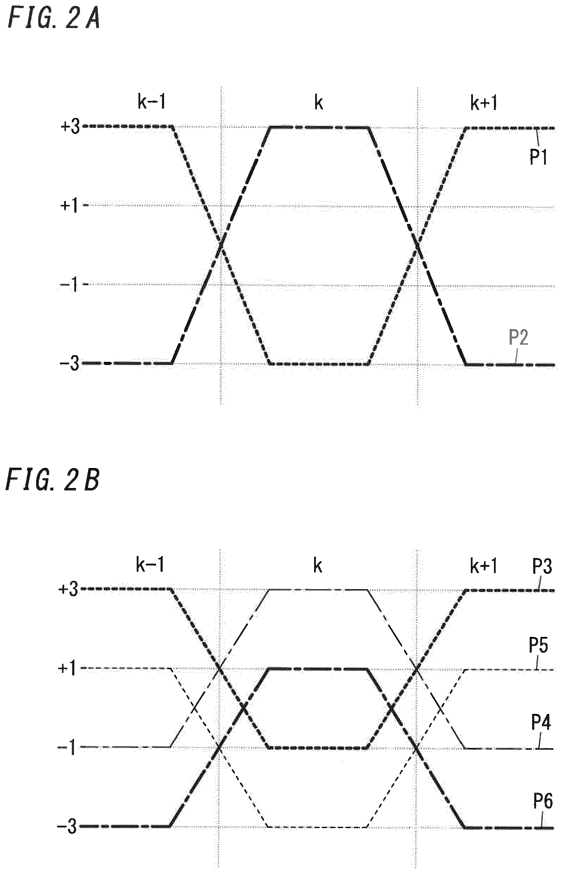

From the above point of view, in the present embodiment, six patterns P1 to P6 as shown in FIG. 2A and FIG. 2B are selected as prohibited patterns. Note that, in FIG. 2A and FIG. 2B, k represents the second symbol of the three consecutive symbols.

As shown in FIG. 2A, the pattern P1 is a pattern in which a signal level transitions to have +3, -3, and +3 in this order. In summary, the signal level is +3 in the encoding time period of the (k-1)-th symbol, -3 in the encoding time period of the k-th symbol next thereto, and +3 in the encoding time period of the (k+1)-th symbol next thereto.

As shown in FIG. 2A, the pattern P2 is a pattern in which a signal level transitions to have -3, +3, and -3 in this order.

These patterns P1 and P2 are patterns in which a signal level is transitioned from a current value (-3 or +3) to a value (+3 or -3) which is neither a value (-1) larger than and next to the current value, nor a value (+1) smaller than and next to the current value. Therefore, the patterns P1 and P2 require maximum change in a signal level. Especially, the patterns P1 and P2 are patterns in which a signal level transitions between a maximum value (+3) and a minimum value (-3) and therefore require large change in a signal level. Therefore, the patterns P1 and P2 may tend to cause an overshoot or undershoot of a signal level. Further, the patterns P1 and P2 are patterns in which increase and decrease in a signal level occur, and each have an extremum. Therefore, transmission signals with the patterns P1 and P2 each contain a high proportion of high frequency components. In this regard, when it is difficult or impossible for transmission paths or intermediate circuits to follow high frequency components, waveforms of rising edges or falling edges of transmission signals may become blunt. Accordingly, openings of eye patterns may be made to be smaller. Especially, degradation of waveforms in width directions (time axis directions) may be caused. Accordingly, setting the patterns P1 and P2 as the prohibited patterns may contribute to reduction of degradation of waveforms caused by transmission.

As shown in FIG. 2B, the pattern P3 is a pattern in which a signal level transitions to have +3, -1, and +3 in this order. As shown in FIG. 2B, the pattern P4 is a pattern in which a signal level transitions to have -1, +3, and -1 in this order. As shown in FIG. 2B, the pattern P5 is a pattern in which a signal level transitions to have +1, -3, and +1 in this order. As shown in FIG. 2B, the pattern P6 is a pattern in which a signal level transitions to have -3, +1, and -3 in this order.

These patterns P3 and P4 are patterns in which a signal level is transitioned from a current value to a value which is neither a value larger than and next to the current value, nor a value smaller than and next to the current value. In detail, in the patterns P3 and P4, a signal level is transitioned from -1 (current value) to a value (+3) which is neither a value (+1) larger than and next to -1, nor a value (-3) smaller than and next to -1. Further, a signal level is transitioned from +3 (current value) to a value (-1) which is neither a value (non-existence) larger than and next to +3, nor a value (+1) smaller than and next to +3. Therefore, the patterns P3 and P4 require large change in a signal level. Therefore, the patterns P3 and P4 may tend to cause an overshoot or undershoot of a signal level. Further, the patterns P3 and P4 are patterns in which increase and decrease in a signal level occur and each have an extremum, and therefore may easily cause occurrence of high frequency components. Accordingly, setting the patterns P3 and P4 as the prohibited patterns may contribute to reduction of degradation of waveforms caused by transmission.

In addition, the patterns P5 and P6 are patterns in which a signal level is transitioned from a current value to a value which is neither a value larger than and next to the current value, nor a value smaller than and next to the current value. In detail, in the patterns P5 and P6, a signal level is transitioned from +1 (current value) to a value (-3) which is neither a value (+3) larger than and next to +1, nor a value (-1) smaller than and next to +1. Further, a signal level is transitioned from -3 (current value) to a value (+1) which is neither a value (-1) larger than and next to -3, nor a value (non-existence) smaller than and next to -3. Therefore, the patterns P5 and P6 require large change in a signal level. Therefore, the patterns P5 and P6 may tend to cause an overshoot or undershoot of a signal level. Further, the patterns P5 and P6 are patterns in which increase and decrease in a signal level occur and each have an extremum, and therefore may easily cause occurrence of high frequency components. Accordingly, setting the patterns P5 and P6 as the prohibited patterns may contribute to reduction of degradation of waveforms caused by transmission.

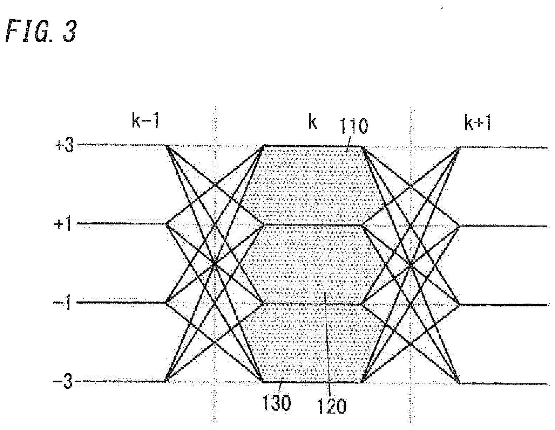

Hereinafter, the patterns P3 to P6 are described in detail. FIG. 3 is illustration for examples representing openings 110, 120, and 130 of ideal eye patterns of transmission signals. Irrespective of change in a signal level, when rise time and fall time are same, regions indicated by dots in FIG. 3 correspond to the openings 110, 120, and 130 of the eye patterns.

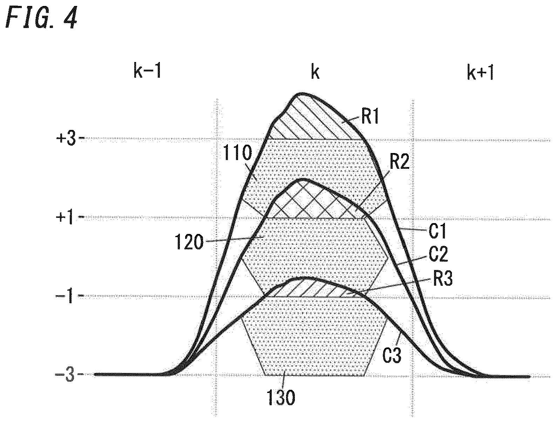

FIG. 4 is illustration for signal waveforms of transmission signals in a case where an overshoot occurs. FIG. 4 shows transmission signals C1, C2 and C3. In the transmission signal C1, regarding three consecutive symbols k-1, k and k+1, the signal level transitions (changes) to have a value of -3, +3, and -3 in this order. In summary, the transmission signal C1 has the pattern P2. In the transmission signal C2, regarding three consecutive symbols k-1, k and k+1, the signal level transitions (changes) to have a value of -3, +1, and -3 in this order. In summary, the transmission signal C2 has the pattern P6. In the transmission signal C3, regarding three consecutive symbols k-1, k and k+1, the signal level transitions (changes) to have a value of -3, -1, and -3 in this order.

In this regard, overshoots that contribute to decrease in the opening of the eye pattern are individual parts corresponding to a region R2 and a region R3 in FIG. 4. Regarding the transmission signal C1 having the pattern P2, a region R1 corresponding to an overshoot is large but is outside the opening 110 of the eye pattern and therefore hardly gives substantial influence on the opening 110 of the eye pattern. The region R3 which is caused by an overshoot of the transmission signal C3 has small high frequency components, and therefore magnitude of the overshoot tends to be smaller. In contrast, the region R2 corresponding to the transmission signal C2 having the pattern P6 has a large area, and may decrease the area of the opening 110 of the eye pattern by an area corresponding thereto, and in particular may cause decrease in the opening of the eye pattern in the height direction (amplitude direction).

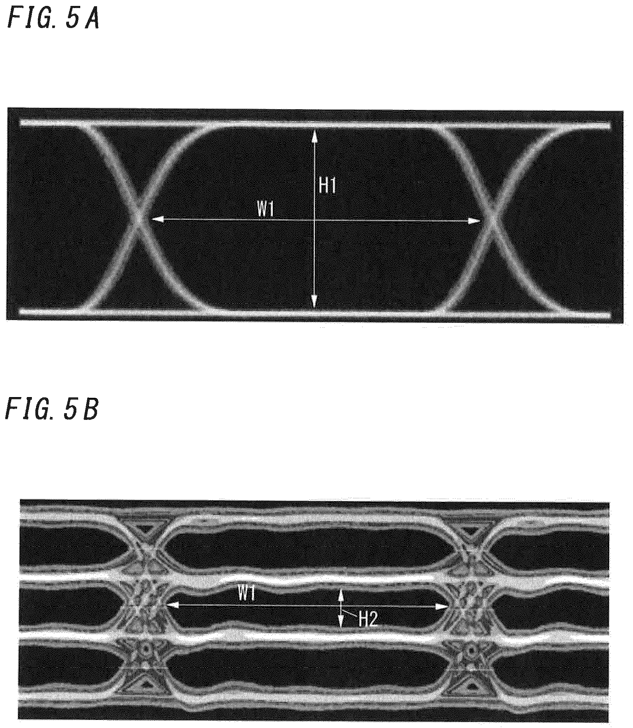

Regarding modulation schemes in which multi levels are set in the height direction, such as PAM4, decrease in the opening of the eye pattern in the height direction described above may cause very large influence on transmission properties, and may cause large increase in a reception error rate at a receiver. In this regard, FIG. 5A shows an eye pattern of a two level signal waveform and FIG. 5B shows an eye pattern of a PAM4. Double-headed arrows H1 and H2 in FIG. 5A and FIG. 5B indicate heights of the eye patterns and double-headed arrows W1 and W2 in FIG. 5A and FIG. 5B indicate widths of the eye pattern. It may be considered that the larger the height and the width of the opening of the eye pattern become, the larger a margin for a noise becomes.

Especially, in a PAM4 signal, a margin in the height direction (amplitude direction) of the opening of the eye pattern easily comes into question. The reason is that, when the number of levels is increased to four in the amplitude direction while the output level is kept equal to that of a two level signal, the height of the opening of the eye pattern becomes one-third of that of the two level signal waveform, and a noise margin also becomes one-third of that of the two level signal waveform. In summary, the margin in the height direction of the opening of the eye pattern decreases with increase in the number of levels. A method of increasing the output level relative to increase in the number of levels may be considered. However, this method may cause increase in power consumption of circuitry. Therefore, effects of the pattern P6 become larger for a signal with multi levels in the amplitude direction.

Note that, causes for such an overshoot may include influences due to frequency properties of systems such as amplifiers, transmission paths, and parasitic impedance accompanied thereby. Further, in a case of a system using optical transmission, influences of optical devices may be included in examples of the causes. The optical transmission sees less attenuation and high noise resistance and therefore has advantages in high speed transmission causing decreases in NF and attenuation properties of systems, and long-distance transmission. In view of this, as described above, in the present embodiment, the sending device 20 and the receiving device 30 are configured to communicate with each other by an optical transmission scheme.

In this regard, examples of causes of occurrence of overshoots in signals in optical transmission may include a phenomenon due to a relaxation oscillation of VCSEL. This is a phenomenon of enhancing an oscillation at a certain frequency and can be controlled by changing a bias current of the VCSEL. For example, influence caused by this phenomenon can be reduced by decreasing the bias current. However, in this case, a cutoff frequency of the VCSEL may decrease. Decrease in the cutoff frequency may cause decrease in an allowable transmission speed, and therefore there may be demerits that it becomes unsuitable for a high speed system.

Examples of causes of enhancing overshoots may include occurrence of gain peaks in a TIA at a certain frequency. This may be caused by occurrence of reversal of a phase between an input and an output of a TIA due to parasitic impedance present due to installation of a PD and/or a TIA or a depletion layer capacitance in a PD. In an extreme case, this may cause an oscillation phenomenon. When this frequency overlaps with a rising frequency, a large overshoot may occur, and the opening of the eye pattern is closed.

Note that, in a case of making electrical connection by wire-bonding, the aforementioned parasitic impedance may occur due to connection wire (mainly, an inductance) or a parasitic capacitance present on a substrate. The depletion layer capacitance of the PD may occur and change due to a reverse bias voltage to the PD. For example, in a case of a system with a transmission speed of 10 G symbol/sec, rising part may contains a large amount of a component of 15 GHz which is a third harmonic component. Such a high frequency component may cause increase in a phase rotation due to parasitic impedance. In most case, the depletion layer capacitance of the PD ranges from 0.1 to 0.5 pF. For example, when the depletion layer capacitance is 0.3 pF and a parasitic inductance is 0.37 nH, a resonance frequency thereof is about 15 GHz. This means that, when a parasitic inductance is converted into a length of bonding wire by 1 nH/mm, a length of such wire is required to be equal to or shorter than 0.37 mm at least. This may put strict restriction on structures and manufacture processes.

The encoding method of the present embodiment can reduce a frequency component causing a gain peak contained in an original signal and therefore can easily apply to a higher speed system. This may apply to a relaxation oscillation frequency of the VCSEL described above. In many cases, such a gain peak frequency or a relaxation oscillation frequency may present near a cutoff frequency of a corresponding system and may be a high frequency. Especially, when these frequency components are near third harmonic components of transmission signals, such effects can be enhanced. As described above, configuration of the present embodiment can offer great advantageous effects even in optical transmission systems. Note that, optical transmission can offer advantages that a stable signal quality can be obtained even for a high frequency range. The present embodiment can reduce troubles which may occur in a high frequency band of optical devices. Therefore, application of the encoding method of the present embodiment to optical transmission can enhance merits of such optical transmission.

Note that, the aforementioned overshoot is described in relation to the symbol k in FIG. 4. Regarding the symbol k+1, decrease in the height direction of the opening of the eye pattern can be reduced when the pattern P5 is included in the one or more prohibited patterns. In summary, this effect can be obtained as long as a pattern includes transition from -3 to +1. Especially, in a case of a sudden change in which a value next to +1 is -3, decrease in the height direction of the opening of the eye pattern can be reduced largely. Note that, in this regard, description is given to overshoots. However, regarding undershoots, setting the one or more prohibited patterns can reduce decrease in the height direction of the opening of the eye pattern, too. Further, including the pattern P3 and P4 in the one or more prohibited patterns can also reduce decrease in the height direction of the opening of the eye pattern. In this case, this effect can be obtained as long as a pattern includes transition from +3 to -1. Especially, in a case of a sudden change in which a value next to -1 is +3, decrease in the height direction (amplitude direction) of the opening of the eye pattern can be reduced largely.

Next, shown in TABLE 1 is a conversion table for encoding the partial bit sequence into the partial symbol sequence which is constituted by 1+p (five) symbols and does not include the one or more prohibited patterns. In the present embodiment, the partial bit sequence includes 8 bits, and the number of combinations thereof is 256. Accordingly, TABLE 1 shows the conversion table partially omitted. In TABLE 1, S[0], S[1], S[2], S[3], and S[4] correspond to the first, second, third, fourth, and fifth symbols of the partial symbol sequence, respectively. Further, in TABLE 1, the total means the sum of signal levels of the first, second, third, fourth, and fifth symbols.

**[TABLE 1]**

| Partial Bit Sequence | Partial Symbol Sequence | | | | | |
|---|---|---|---|---|---|---|
| | S[0] | S[1] | S[2] | S[3] | S[4] | Total |
| 00000000 | +3 | +1 | +3 | +3 | +3 | +13 |
| | -3 | -1 | -3 | -3 | -3 | -13 |
| . | . | . | . | . | . | . |
| . | . | . | . | . | . | . |
| 00001000 | +1 | +1 | +3 | +3 | +3 | +11 |
| | -1 | -1 | -3 | -3 | -3 | -11 |
| . | . | . | . | . | . | . |
| . | . | . | . | . | . | . |
| 00001100 | +1 | -1 | +3 | +3 | +1 | +7 |
| | -1 | +1 | -3 | -3 | -1 | -7 |
| . | . | . | . | . | . | . |
| . | . | . | . | . | . | . |
| 00100011 | -1 | +1 | +1 | +1 | +1 | +3 |
| | +1 | -1 | -1 | -1 | -1 | -3 |
| . | . | . | . | . | . | . |
| . | . | . | . | . | . | . |
| 00110011 | -1 | -1 | +3 | +3 | +1 | +5 |
| | +1 | +1 | -3 | -3 | -1 | -5 |
| . | . | . | . | . | . | . |
| . | . | . | . | . | . | . |
| 01100100 | -3 | -1 | +3 | +1 | -1 | -1 |
| . | . | . | . | . | . | . |
| . | . | . | . | . | . | . |
| 11100110 | +3 | +1 | +3 | +1 | -1 | +7 |
| | -3 | -1 | -3 | -1 | +1 | -7 |
| . | . | . | . | . | . | . |
| . | . | . | . | . | . | . |
| 11111111 | +1 | +1 | +1 | +1 | -1 | 3 |

In this regard, in an encoding method of a general four level pulse amplitude modulation, mutually different four values are individually associated with four combinations of two bits. In a concrete example, combinations of bits of "10", "11", "01 ", and "00" are individually converted into signal levels with values of "+3", "+1", "-1", and "-3".

According to the encoding method of the general four level pulse amplitude modulation, the partial bit sequence of "00001000" is encoded into the symbol sequence of "-3, +3, -3, -3". Note that, this symbol sequence is obtained by encoding every two bits of the partial bit sequence from the right side thereof. This symbol sequence includes the prohibited pattern of "-3, +3, -3" (the pattern P2). In contrast, the partial symbol sequences corresponding to the partial bit sequence of "00001000" are "+1, +1, +3, +3, +3" and "-1, -1, -3, -3, -3" and do not include any of the prohibited patterns (the patterns P1 to P6).

Similarly, according to the encoding method of the general four level pulse amplitude modulation, the symbol sequences respectively obtained from the partial bit sequences of "00001100", "00100011", "00110011", "01100100", and "11100110" each include any of the prohibited patterns. In contrast, the partial symbol sequences individually corresponding to the partial bit sequences each do not include any of the prohibited patterns (the patterns P1 to P6).

Accordingly, the conversion table enables encoding a partial bit sequence into a partial symbol sequence which does not include any of the prohibited patterns (P1 to P6).

Further, each partial symbol sequence is set not to show any prohibited pattern (P1 to P6) even when it is followed by any partial symbol sequence. Such setting can be realized by adjusting signal levels of first two symbols (the first and second symbols) and last two symbols (the fourth and fifth symbols) of each partial symbol sequence. In the present embodiment, an absolute value of a difference between the first two symbols (the first and second symbols) is set to 0 or 2 (the minimum interval between values of the signal level). Similarly, an absolute value of a difference between the last two symbols (the fourth and fifth symbols) is set to 0 or 2 (the minimum interval between values of the signal level), too. Accordingly, the symbol sequence constituted by a plurality of partial symbol sequences may be prevented from including the one or more prohibited patterns (PI to P6). As described above, the partial symbol sequences are preferably set so that a combination of any two of the partial symbol sequences does not show the one or more prohibited patterns.

Further, as obvious from TABLE 1 shown above, in the conversion table, a predetermined partial bit sequence is associated with not one but two partial symbol sequences. One of the two partial symbol sequences is set to have its total being positive, and the other is set to have its total being negative. For example, the partial bit sequence of "00001000" is associated with the partial symbol sequence of "+1, +1, +3, +3, +3" and the partial symbol sequence of "-1, -1, -3, -3, -3".

In this regard, the encoding step includes calculating a sum of totals of the partial symbol sequences. The encoding step further includes encoding a predetermined partial bit sequence into any of the two partial symbol sequences in accordance with the sum. In detail, when the sum is equal to or larger than 0, the predetermined partial bit sequence is encoded into the partial symbol sequence with its total being negative. When the sum is smaller than 0, the predetermined partial bit sequence is encoded into the partial symbol sequence with its total being positive. Consequently, it may be easy to improve DC balance.

Further, the encoding step includes outputting the resultant partial symbol sequence to the transmitter 22.

The aforementioned encoding device 21 may be realized by a microcomputer including one or more memories and one or more processors, for example. In other words, the one or more processors execute one or more programs stored in the one or more memories, and thereby the encoding device 21 can perform the aforementioned encoding method (encoding process).

The decoding device 32 is configured to decode a symbol sequence into a bit sequence to be transmitted, by a decoding process corresponding to the encoding process of the encoding method described above. The decoding process includes a decoding step and a merging step.

The decoding step is a step of decoding a partial symbol sequence into a partial bit sequence by use of a conversion table predetermined. This conversion table is same as the conversion table used in the encoding step (see TABLE 1). The decoding step directly converts a partial symbol sequence into a partial bit sequence by the predetermined conversion table, and therefore the decoding process can be performed easily.

The merging step is a step of combining two or more partial bit sequences obtained by decoding in the decoding step to form the bit sequence to be transmitted, and outputting it.

The aforementioned decoding device 32 may be realized by a microcomputer including one or more memories and one or more processors, for example. In other words, the one or more processors execute one or more programs stored in the one or more memories, and thereby the decoding device 32 can perform the aforementioned decoding method (decoding process).

As described above, the transmission device 10 of the present embodiment includes: the encoding device 21 configured to encode a bit sequence to be transmitted, into a symbol sequence; and a transmitter 22 configured to send a transmission signal representing the symbol sequence from the encoding device 21. Additionally, the transmission device 10 includes: the receiver 31 configured to receive the transmission signal sent from the transmitter; and the decoding device 32 configured to decode the symbol sequence obtained from the transmission signal received by the receiver 31 into the bit sequence to be transmitted.

### 1.2 Operation

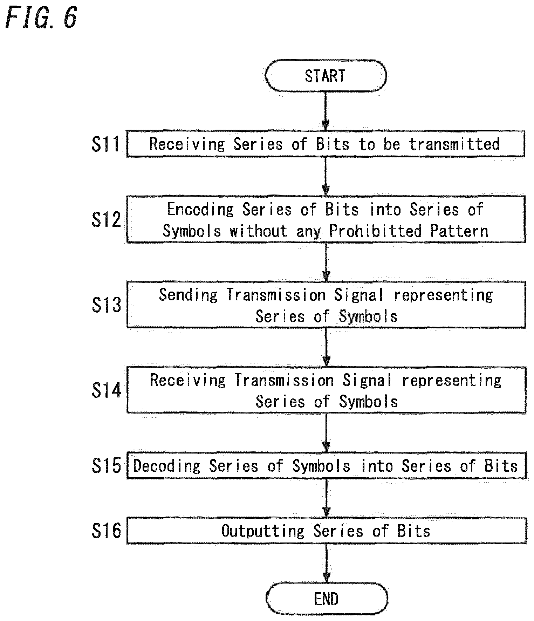

Hereinafter, operation of the transmission device 10 is described briefly with reference to FIG. 6. First, in the transmission device 10, the encoding device 21 of the sending device 20 receives a bit sequence to be transmitted (S11). Next, the encoding device 21 performs the aforementioned encoding method, thereby encoding a bit sequence (partial bit sequences) into a symbol sequence (partial symbol sequences) free from any prohibited pattern (patterns P1 to P6) (S12). the transmitter 22 of the sending device 20 sends a transmission signal representing the symbol sequence (the partial symbol sequences) obtained from the encoding device 21 (S13). The receiver 31 of the receiving device 30 receives the transmission signal sent from the transmitter 22 (the transmission signal representing the symbol sequence) (S14). And, the decoding device 32 of the receiving device 30 performs the aforementioned decoding method, thereby decoding the symbol sequence (the partial symbol sequences) into the bit sequence (the partial bit sequences) (S15). The decoding device 32 outputs the bit sequence (S16).

As described above, the transmission device 10 of the present embodiment performs a transmission method including the aforementioned encoding method and the aforementioned decoding method, thereby transmitting the bit sequence to be transmitted, from the sending device 20 to the receiving device 30.

### 1.3 Measurement Results

To confirm advantageous effects of the transmission device 10 of the present embodiment, receiver-side eye patterns (eye patterns of transmission signals received by receivers) were measured for each of the transmission device 10 of the present embodiment and a transmission device of a comparative example. Referring to openings of the receiver-side eye patterns enable evaluation of degree of degradation of waveforms caused by transmission. In detail, the openings of the receiver-side eye patterns increase with decrease in degradation of waveforms caused by transmission. Further, increase in the openings of the receiver-side eye patterns facilitates identification of signal levels of the plurality of symbols constituting the symbol sequence. Consequently, decrease in a transmission error rate can be expected.

The transmission device of the comparative example is different from the transmission device 10 of the present embodiment in that the transmission device of the comparative example uses not the encoding method and the decoding method (i.e., the transmission method) of the above embodiment but the encoding method and the decoding method of a general four level pulse amplitude modulation. In summary, in the transmission device of the comparative example, the symbol sequence includes the one or more prohibited patterns (P1 to P6). Note that, a bit sequence to be transmitted, given to the transmission device 10 of the present embodiment and the transmission device of the comparative example was a bit sequence selected randomly.

Measurement of the receiver-side eye patterns was conducted by measuring an output from a photodiode amplified by the TIA of the receiver, with an oscilloscope.

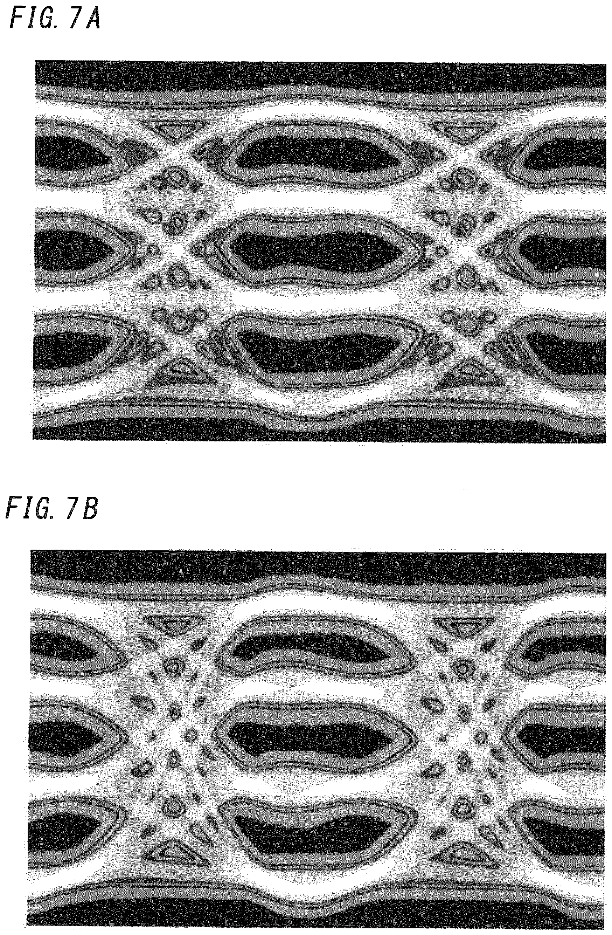

FIG. 7A and FIG. 7B show measurement results of the receiver-side eye patterns. In this regard, FIG. 7A shows the receiver-side eye pattern of the transmission device 10 of the present embodiment and FIG. 7B relates to the comparative example and shows the receiver-side eye pattern of the transmission device using a pseudorandom code which is well used generally and is referred to as a pseudorandom binary sequence (PRBS). Note that, the pseudorandom code used herein is a PRBS7 and is a code with every cycle constituted by (2⁷-1) bits.

As obvious from FIG. 7A and FIG. 7B, the receiver-side eye pattern of the transmission device 10 of the present embodiment has openings (upper, middle, and lower openings) which are totally wider than those of the receiver-side eye pattern of the transmission device of the comparative example. In detail, as to the upper opening, the width is improved by 70.5 % and the height is improved by 97.1 %. As to the middle opening, the width is improved by 7.8 % and the height is improved by 25.6 %. As to the lower opening, the width is improved by 1.1 % and the height is improved by 30.8 %. Improvement of the upper opening is particularly-large and this is an effect obtained by setting the pattern P6 as the prohibited pattern. Especially, in FIG. 7B, the pattern P6 causes large decrease in the upper opening of the eye pattern. As already described above, this effect is particularly-large in the height direction. Note that, improvement of the width of the opening of the eye pattern is larger than it appears. The reason is that the improvement rate of the width is calculated based on a distance along a straight line across an initially decided threshold value. In FIG. 7B, a protrusion which decreases the opening of the eye pattern crosses the straight line and thus the calculated width of the opening is smaller than the width of the opening appears.

According to these measurement results of the receiver-side eye patterns, it is confirmed that the transmission device 10 of the present embodiment can reduce degradation of waveforms caused by transmission in contrast to the transmission device of the comparative example (the encoding method of the general four level pulse amplitude modulation).

### 1.4 Conclusion

As described above, the transmission device 10 includes the encoding device 21 configured to perform the encoding method. This encoding method includes the encoding process of encoding a bit sequence to be transmitted, into a symbol sequence. The symbol sequence is constituted by a plurality of symbols each having a signal level to which any one of four different values is allocated. The four different values are the first value (+3), the second value (+1), the third value (-1), and the fourth value (-3) which are in descending order. The encoding process encodes the bit sequence to be transmitted, into the symbol sequence so that the symbol sequence does not include any of prohibited patterns. The prohibited patterns include specific patterns which are patterns representing transition of signal levels of three or more consecutive symbols. The specific patterns include the pattern P1 with its signal level transitioning to have the first value, the fourth value, and the first value in this order, and the pattern P2 with its signal level transitioning to have the fourth value, the first value, and the fourth value in this order.

Further, the specific patterns include the pattern P3 with its signal level transitioning to have the first value, the third value, and the first value in this order, and the pattern P4 with its signal level transitioning to have the third value, the first value, and the third value in this order. Furthermore, the specific patterns include the pattern P5 with its signal level transitioning to have the second value, the fourth value, and the second value in this order, and the pattern P6 with its signal level transitioning to have the fourth value, the second value, and the fourth value in this order.

As described above, the symbol sequence does not include any of the patterns P1 to P6 considered as cause of degradation of waveforms caused by transmission. Therefore, the encoding method, the decoding method, the transmission method, the decoding device, the encoding device, and the transmission device, of the present embodiment can offer advantageous effect of reducing degradation of waveforms caused by transmission.

### 2. Embodiment 2

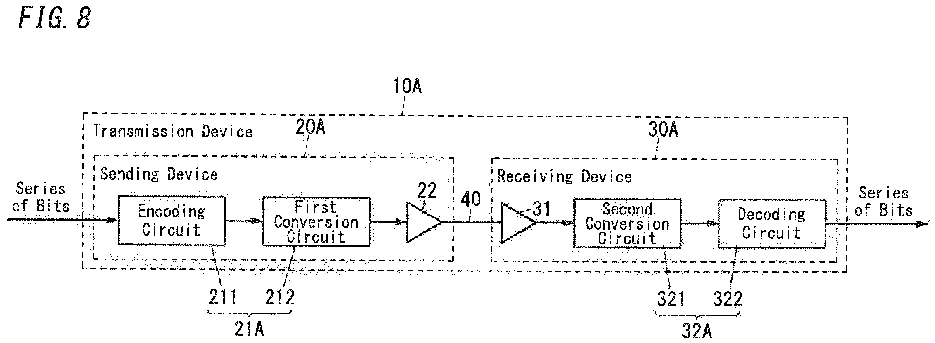

FIG. 8 shows a transmission device 10A of Embodiment 2. The transmission device 10A includes a sending device 20A and a receiving device 30A.

The sending device 20A includes: an encoding device 21A configured to encode a bit sequence to be transmitted, into a symbol sequence; and a transmitter 22 configured to output a transmission signal to the transmission line 40 based on the symbol sequence generated by the encoding device 21A.

The encoding device 21A is configured to perform an encoding method. The encoding method includes an encoding process of encoding a bit sequence to be transmitted, into a symbol sequence.

The encoding process includes an obtaining step, an encoding step, and a (first) converting step.

The obtaining step is a step of obtaining a partial bit sequence constituted by m bits, from the bit sequence to be transmitted. m is a multiple of n. In the present embodiment, m is 8. In summary, due to the obtaining step, the partial bit sequence of 8 bits is obtained from the bit sequence to be transmitted.

The encoding step is a step of encoding the partial bit sequence into a first partial symbol sequence which is constituted by 1 symbols so that 2ⁿ different values of the signal level represent combinations of n bits. In this regard, n is 2 and 1 is a value obtained by dividing m by n. In summary, the encoding step encodes the partial bit sequence of 8 bits into the first partial symbol sequence of 4 symbols. In the encoding step, the encoding method of the general four level pulse amplitude modulation may apply. Therefore, values of "+3", "+1", "-1", and "-3" are allocated to combinations of "10", "11", "01", and "00", respectively.

The first converting step is a step of converting, by use of a predetermined conversion table, the first partial symbol sequence into a second partial symbol sequence constituted by 1+p symbols and does not include the one or more prohibited patterns. In this regard, p is an integer equal to or larger than 1. In the present embodiment, p is 1. In summary, in the first converting step, the first partial symbol sequence of 4 symbols is converted into the second partial symbol sequence of 5 symbols. Note that, the one or more prohibited patterns include the patterns P1 to P6 as already described in relation to Embodiment 1.

TABLE 2 shows the conversion table for encoding a first partial symbol sequence into a second partial symbol sequence which is constituted by 1+p (five) symbols and does not include the one or more prohibited patterns. In the present embodiment, the partial bit sequence includes 8 bits, and the number of combinations thereof is 256. Accordingly, TABLE 2 shows the conversion table partially omitted. In TABLE 2, S1[0], S1[1], S1[2], and S1[3] correspond to the first, second, third, and fourth symbols of the first partial symbol sequence, respectively. Further in TABLE 2, S2[0], S2[1], S2[2], S2[3], and S2[4] correspond to the first, second, third, fourth, and fifth symbols of the second partial symbol sequence, respectively. Furthermore in TABLE 2, the total means the sum of signal levels of the first, second, third, fourth, and fifth symbols of the second partial symbol sequence.

**[TABLE 2]**

| First Partial Symbol Sequence | | | | Second Partial Symbol Sequence | | | | | |
|---|---|---|---|---|---|---|---|---|---|
| S1[0] | S1[1] | S1[2] | S1[3] | S2[0] | S2[1] | S2[2] | S2[3] | S2[4] | Total |
| -3 | -3 | -3 | -3 | +3 | +1 | +3 | +3 | +3 | +13 |
| | | | | -3 | -1 | -3 | -3 | -3 | -13 |
| . | . | . | . | . | . | . | . | . | . |
| . | . | . | . | . | . | . | . | . | . |
| -3 | +3 | -3 | -3 | +1 | +1 | +3 | +3 | +3 | +11 |
| | | | | -1 | -1 | -3 | -3 | -3 | -11 |
| . | . | . | . | . | . | . | . | . | . |
| . | . | . | . | . | . | . | . | . | . |
| -3 | +1 | -3 | -3 | +1 | -1 | +3 | +3 | +1 | +7 |
| | | | | -1 | +1 | -3 | -3 | -1 | -7 |
| . | . | . | . | . | . | . | . | . | . |
| . | . | . | . | . | . | . | . | . | . |
| -1 | +3 | -3 | +3 | -1 | +1 | +1 | +1 | +1 | +3 |
| | | | | +1 | -1 | -1 | -1 | -1 | -3 |
| . | . | . | . | . | . | . | . | . | . |
| . | . | . | . | . | . | . | . | . | . |
| +3 | -1 | +3 | -3 | -1 | -1 | +3 | +3 | +1 | +5 |
| | | | | +1 | +1 | -3 | -3 | -1 | -5 |
| . | . | . | . | . | . | . | . | . | . |
| . | . | . | . | . | . | . | . | . | . |
| -3 | -1 | +3 | -1 | -3 | -1 | +3 | +1 | -1 | -1 |
| . | . | . | . | . | . | . | . | . | . |
| . | . | . | . | . | . | . | . | . | . |
| +3 | -1 | +3 | +1 | +3 | +1 | +3 | +1 | -1 | +7 |
| | | | | -3 | -1 | -3 | -1 | +1 | -7 |
| . | . | . | . | . | . | . | . | . | . |
| . | . | . | . | . | . | . | . | . | . |
| +1 | +1 | +1 | +1 | +1 | +1 | +1 | +1 | -1 | +3 |

According to the encoding method of the general four level pulse amplitude modulation, the partial bit sequence of "00001000" is encoded into the first partial symbol sequence of "-3, +3, -3, -3". Note that, this first partial symbol sequence is obtained by encoding every two bits of the partial bit sequence from the right side thereof. This first partial symbol sequence includes the prohibited pattern of "-3, +3, -3" (the pattern P2). In contrast, the second partial symbol sequences corresponding to the first partial symbol sequence of "-3, +3, -3, -3" are "+1, +1, +3, +3, +3" and "-1, -1, -3, -3, -3" and do not include any of the prohibited patterns (the patterns P1 to P6).

Similarly, the first partial symbol sequences of "-3, +1, -3, -3", "-1, +3, -3, +3", "+3, -1, +3, -3", "-3, -1, +3, -1", and "+3, -1, +3, +1" each include any of the prohibited patterns (the patterns P1 to P6). Similarly, In contrast, the second partial symbol sequences individually corresponding to the first partial bit sequences each do not include any of the prohibited patterns (the patterns P1 to P6).

Accordingly, the conversion table enables converting a first partial bit sequence into a second partial symbol sequence which does not include any of the prohibited patterns (P1 to P6).

Further, each second partial symbol sequence is set not to show any prohibited pattern (P1 to P6) even when it is followed by any second partial symbol sequence. Such setting can be realized by adjusting signal levels of first two symbols (the first and second symbols) and last two symbols (the fourth and fifth symbols), in a similar manner to partial symbol sequences of Embodiment 1.

Further, as obvious from TABLE 2 shown above, in the conversion table, a predetermined first partial bit sequence is associated with not one but two second partial symbol sequences. One of the two second partial symbol sequences is set to have its total being positive, and the other is set to have its total being negative. For example, the first partial bit sequence of "-3, +3, -3, -3" is associated with the second partial symbol sequence of "+1, +1, +3, +3, +3" and the second partial symbol sequence of "-1, -1, -3, -3, -3".

In this regard, the first converting step includes calculating a sum of totals of the second partial symbol sequences. The first converting step further includes converting a predetermined first partial bit sequence into any of the two second partial symbol sequences in accordance with the sum. In detail, when the sum is equal to or larger than 0, the predetermined first partial bit sequence is encoded into the second partial symbol sequence with its total being negative. When the sum is smaller than 0, the predetermined first partial bit sequence is encoded into the second partial symbol sequence with its total being positive. Consequently, it may be easy to improve DC balance.

Further, the first converting step includes outputting the resultant second partial symbol sequence to the transmitter 22.

As shown in FIG. 8, the encoding device 21A includes an encoding circuit 211 and a (first) conversion circuit 212. The encoding circuit 211 is configured to perform the obtaining step and the encoding step of the encoding process, and the first conversion circuit 212 is configured to perform the first converting step. In summary, the encoding circuit 211 is equivalent to an encoding device performing the encoding method of the general four level pulse amplitude modulation. Therefore, addition of the first conversion circuit 212 (the first converting step) can convert the encoding method of the general four level pulse amplitude modulation into the encoding method of the present embodiment.

Note that, the encoding circuit 211 and the first conversion circuit 212 may be realized by a microcomputer including one or more memories and one or more processors, for example. In other words, the one or more processors execute one or more programs stored in the one or more memories, and thereby the encoding circuit 211 can perform the obtaining step and the encoding step of the encoding method (the encoding process) described above. Further, the one or more processors execute one or more programs stored in the one or more memories, and thereby the first conversion circuit 212 can perform the first converting step of the encoding method (the encoding process) described above.

The transmitter 22 is configured to output the symbol sequence (the second partial symbol sequence) to the transmission line 40 by an optical transmission scheme. This transmitter 22 can be realized by use of one or more light emitting diodes, and configuration thereof may be conventional and thus detailed description thereof is omitted.

The receiving device 30A includes: a receiver 31 configured to receive a transmission signal from the transmitter 22 via the transmission line 40 and extract a symbol sequence (a second partial symbol sequence); and a decoding device 32A configured to decode the symbol sequence extracted by the receiver 31 into a bit sequence.

The receiver 31 is configured to receive a transmission signal via the transmission line 40 by an optical transmission scheme, extract a symbol sequence (a second partial symbol sequence) from the transmission signal received, and output it to the decoding device 32A. This receiver 31 can be realized by use of one or more photodiodes, and configuration thereof may be conventional and thus detailed description thereof is omitted.

The decoding device 32A is configured to decode a symbol sequence into a bit sequence to be transmitted, by use of the decoding process corresponding to the encoding process of the encoding method described above. The decoding process includes a (second) converting step, a decoding step, and a merging step.

The second converting step is a step of converting the second partial symbol sequence into the first partial bit sequence by use of a conversion table predetermined. This conversion table is same as the conversion table used in the first converting step (see TABLE 2).

The decoding step is a step of decoding the first partial symbol sequence which is constituted by 1 symbols each having a signal level to which any one of the 2ⁿ different values is allocated, into the partial bit sequence constituted by m bits. In this regard, 1 is a value obtained by dividing m by n. Further, in the present embodiment, n is 2 and m is 8. In summary, the decoding step decodes the first partial symbol sequence of 4 symbols into the partial bit sequence of 8 bits. In the decoding step, the decoding method of the general four level pulse amplitude modulation may apply. Therefore, values of "+3", "+1", "-1", and "-3" are allocated to combinations to two bits of "10", "11 ", "01", and "00", respectively.

The merging step is a step of combining two or more partial bit sequences obtained by decoding in the decoding step to form the bit sequence to be transmitted, and outputting it.

As shown in FIG. 8, the decoding device 32A includes a (second) conversion circuit 321 and a decoding circuit 322. The second conversion circuit 321 is configured to perform the second converting step of the decoding process, and the decoding circuit 322 is configured to perform the decoding step and the merging step of the decoding process. In summary, the decoding circuit 322 is equivalent to a decoding device performing the decoding method of the general four level pulse amplitude modulation. Therefore, addition of the second conversion circuit 321 (the second converting step) can convert the decoding method of the general four level pulse amplitude modulation into the decoding method of the present embodiment.

Note that, the second conversion circuit 321 and the decoding circuit 322 may be realized by a microcomputer including one or more memories and one or more processors, for example. In other words, the one or more processors execute one or more programs stored in the one or more memories, and thereby the second conversion circuit 321 can perform the second converting step of the decoding method (the decoding process) described above. Further, the one or more processors execute one or more programs stored in the one or more memories, and thereby the decoding circuit 322 can perform the decoding step and the merging step of the decoding method (the decoding process) described above.

Apparently, the transmission device 10A of the present embodiment includes: the encoding device 21A configured to encode a bit sequence to be transmitted, into a symbol sequence; and the transmitter 22 configured to send a transmission signal representing the symbol sequence from the encoding device 21A. Further, the transmission device 10A includes: the receiver 31 configured to receive the transmission signal sent from the transmitter; and the decoding device 32A configured to decode the symbol sequence obtained from the transmission signal received by the receiver 31, into the bit sequence to be transmitted.

As described above, the transmission device 10A includes the encoding device 21A for performing the encoding method. Similarly to Embodiment 1, this encoding method includes the encoding process of encoding the bit sequence to be transmitted, into the symbol sequence so that the symbol sequence does not include the one or more prohibited patterns. Similarly to Embodiment 1, the one or more prohibited patterns include the patterns P1 to P6.

Apparently, the symbol sequence does not include any of the patterns P1 to P6 considered as cause of degradation of waveforms caused by transmission. Therefore, the encoding method, the decoding method, the transmission method, the decoding device, the encoding device, and the transmission device, of the present embodiment can offer advantageous effect of reducing degradation of waveforms caused by transmission.

### 3. Embodiment 3

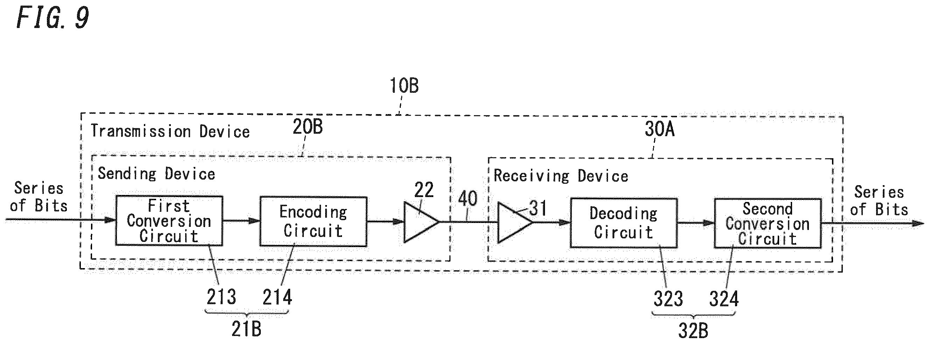

FIG. 9 shows a transmission device 10B of Embodiment 3. The transmission device 10B includes a sending device 20B and a receiving device 30B.

The sending device 20B includes: an encoding device 21B configured to encode a bit sequence to be transmitted, into a symbol sequence; and a transmitter 22 configured to output a transmission signal to the transmission line 40 based on the symbol sequence generated by the encoding device 21B.

The encoding device 21B is configured to perform an encoding method. The encoding method includes an encoding process of encoding a bit sequence to be transmitted, into a symbol sequence.

The encoding process includes an obtaining step, a (first) converting step, and an encoding step.

The obtaining step is a step of obtaining a first partial bit sequence constituted by m bits, from the bit sequence to be transmitted. m is a multiple of n. In the present embodiment, m is 8 and n is 2. In summary, due to the obtaining step, the first partial bit sequence of 8 bits is obtained from the bit sequence to be transmitted.

The first converting step is a step of converting the first partial bit sequence into a second partial bit sequence constituted by m+q bits, by a predetermined conversion procedure. In this regard, q is a multiple of n. In the present embodiment, q is 2. In summary, the first converting step converts the first partial bit sequence of 8 bits into the second partial bit sequence of 10 bits. The conversion procedure of this first converting step may be a conversion procedure for a bit sequence by a general encoding method (e.g., an encoding method generally used in two level transmission such as 8B10B).

The encoding step is a step of encoding the second partial bit sequence into a partial symbol sequence which is constituted by k symbols and does not include the one or more prohibited patterns, by use of a predetermined conversion table. In this regard, k is a value obtained by dividing the sum of m and q by n. In the present embodiment, k is 5. In summary, the encoding step encodes the second partial bit sequence of 10 bits into the partial symbol sequence of 5 symbols. In the encoding step, the second partial bit sequence is converted into the partial symbol sequence directly by use of the predetermined conversion table. Therefore, the encoding process can be facilitated. Note that, the one or more prohibited patterns include the patterns P1 to P6 as already described in relation to Embodiment 1.

TABLE 3 shows the conversion table for encoding to obtain the partial symbol sequence which is constituted by k (five) symbols and does not include the one or more prohibited patterns. Note that, TABLE 3 shows a column of the first partial bit sequence but this column is added only for facilitating understanding and therefore is not contained in the conversion table. In the present embodiment, the first partial bit sequence includes 8 bits, and the number of combinations thereof is 256. Accordingly, TABLE 3 shows the conversion table partially omitted. In TABLE 3, S[0], S[1], S[2], S[3], and S[4] correspond to the first, second, third, fourth, and fifth symbols of the partial symbol sequence, respectively. Further in TABLE 3, the total means the sum of signal levels of the first, second, third, fourth, and fifth symbols of the partial symbol sequence.

**[TABLE 3]**

| First Partial Bit Sequence | Second Partial Bit Sequence | Partial Symbol Sequence | | | | | |
|---|---|---|---|---|---|---|---|
| | | S[0] | S[1] | S[2] | S[3] | S[4] | Total |
| 00000000 | 1111111111 | +3 | +1 | +3 | +3 | +3 | +13 |
| | 0100000000 | -3 | -1 | -3 | -3 | -3 | -13 |
| . | . | . | . | . | . | . | . |
| . | . | . | . | . | . | . | . |
| 00001000 | 0111111000 | +1 | +1 | +3 | +3 | +3 | +11 |
| | 1100000111 | -1 | -1 | -3 | -3 | -3 | -11 |
| . | . | . | . | . | . | . | . |
| . | . | . | . | . | . | . | . |
| 00001100 | 1111111011 | +1 | -1 | +3 | +3 | +1 | +7 |
| | 0100000100 | -1 | +1 | -3 | -3 | -1 | -7 |
| . | . | . | . | . | . | . | . |
| . | . | . | . | . | . | . | . |
| 00100011 | 0111100001 | -1 | +1 | +1 | +1 | +1 | +3 |
| | | +1 | -1 | -1 | -1 | -1 | -3 |
| . | . | . | . | . | . | . | . |
| . | . | . | . | . | . | . | . |
| 00110011 | 1111101110 | -1 | -1 | +3 | +3 | +1 | +5 |
| | 0100010001 | +1 | +1 | -3 | -3 | -1 | -5 |
| . | . | . | . | . | . | . | . |
| . | . | . | . | . | . | . | . |
| 01100100 | 0111101100 | -3 | -1 | +3 | +1 | -1 | -1 |
| | 1100100011 | | | | | | |
| . | . | . | . | . | . | . | . |
| . | . | . | . | . | . | . | . |
| 11100110 | 1011110111 | +3 | +1 | +3 | +1 | -1 | +7 |
| | 0000001000 | -3 | -1 | -3 | -1 | +1 | -7 |
| . | . | . | . | . | . | . | . |
| . | . | . | . | . | . | . | . |
| 11111111 | 0011111111 | +1 | +1 | +1 | +1 | -1 | +3 |
| | 1000000000 | | | | | | |

According to the encoding method of the general four level pulse amplitude modulation, the second partial bit sequence of "0000001000" corresponding to the first partial bit sequence of "11100110" is encoded into the symbol sequence of "-3, +3, -3, -3, -3". Note that, this symbol sequence is obtained by encoding every two bits of the second partial bit sequence from the right side thereof. This symbol sequence includes the prohibited pattern of "-3, +3, -3" (the pattern P2). In contrast, the partial symbol sequence corresponding to the second partial bit sequence of "0000001000" is "-3, -1, -3, -1, +1" and does not include any of the prohibited patterns (the patterns P1 to P6).

Accordingly, the conversion table enables converting a second partial bit sequence into a partial symbol sequence which does not include any of the prohibited patterns (P1 to P6).

Further, each second partial symbol sequence is set not to show any prohibited pattern (P1 to P6) even when it is followed by any second partial symbol sequence. Such setting can be realized by adjusting signal levels of first two symbols (the first and second symbols) and last two symbols (the fourth and fifth symbols), in a similar manner to partial symbol sequences of Embodiment 1.

Further, the first converting step includes outputting the resultant partial symbol sequence to the transmitter 22.

As shown in FIG. 9, the encoding device 21B includes a (first) conversion circuit 213 and an encoding circuit 214. The first conversion circuit 213 is configured to perform the obtaining step and the first converting step of the encoding process, and the encoding circuit 214 is configured to perform the encoding step. In other words, the first conversion circuit 213 is equivalent to a conversion circuit for conversion of bit sequences by a general encoding method (e.g., an encoding method generally used in two level transmission such as 8B10B). Therefore, even when the conversion procedure for bit sequences by a general encoding method for two level transmission is used as the conversion procedure in the (first) converting step, a bit sequence can be converted into the partial symbol sequence encoded by the encoding method of the present embodiment.

Note that, the first conversion circuit 213 and the encoding circuit 214 may be realized by a microcomputer including one or more memories and one or more processors, for example. In other words, the one or more processors execute one or more programs stored in the one or more memories, and thereby the first conversion circuit 213 can perform the obtaining step and the first converting step of the encoding method (the encoding process) described above. Further, the one or more processors execute one or more programs stored in the one or more memories, and thereby the encoding circuit 214 can perform the encoding step of the encoding method (the encoding process) described above.

The receiving device 30B includes: a receiver 31 configured to receive a transmission signal from the transmitter 22 via the transmission line 40 and extract a symbol sequence (a partial symbol sequence); and a decoding device 32B configured to decode the symbol sequence extracted by the receiver 31 into a bit sequence.

The decoding device 32B is configured to decode a symbol sequence into a bit sequence to be transmitted, by a decoding process corresponding to the encoding process of the aforementioned encoding method. The decoding process includes a decoding step, a (second) converting step, and a merging step.

The decoding step is a step of decoding a partial symbol sequence into a second partial bit sequence by use of a conversion table predetermined. This conversion table is same as the conversion table used in the encoding step (see TABLE 3).

The second converting step is a step of converting a second partial bit sequence constituted by m+q bits, into a first partial bit sequence constituted by m bits, by a predetermined conversion procedure. In the present embodiment, n is 2, m is 8, and q is 2. In summary, the second converting step converts a second partial bit sequence of 10 bits into a first partial bit sequence of 8 bits. The conversion procedure of the second converting step is a procedure corresponding to the conversion procedure of the first converting step. For example, the conversion procedure of the second converting step may be a conversion procedure for bit sequences by a general encoding method (e.g., an encoding method generally used in two level transmission such as 8B10B).

The merging step is a step of combining two or more partial bit sequences obtained by converting in the second converting step to form the bit sequence to be transmitted, and outputting it.

As shown in FIG. 9, the decoding device 32B includes a decoding circuit 323 and a (second) conversion circuit 324. The decoding circuit 323 is configured to perform the decoding step of the decoding process. The second conversion circuit 324 is configured to perform the second converting step and the merging step of the decoding process. In other words, the second conversion circuit 324 is equivalent to a conversion circuit for conversion of bit sequences by a general encoding method (e.g., an encoding method generally used in two level transmission such as 8B10B). Therefore, even when the conversion procedure for bit sequences by a general encoding method for two level transmission is used as the conversion procedure in the (second) converting step, the partial symbol sequence encoded by the encoding method of the present embodiment can be decoded into a data sequence.

Note that, the decoding circuit 323 and the second conversion circuit 324 may be realized by a microcomputer including one or more memories and one or more processors, for example. In other words, the one or more processors execute one or more programs stored in the one or more memories, and thereby the decoding circuit 323 can perform the decoding step of the decoding method (the decoding process) described above. Further, the one or more processors execute one or more programs stored in the one or more memories, and thereby the second conversion circuit 324 can perform the second converting step and the merging step of the decoding method (the decoding process) described above.

Apparently, the transmission device 10B of the present embodiment includes: the encoding device 21B configured to encode a bit sequence to be transmitted, into a symbol sequence; and the transmitter 22 configured to send a transmission signal representing the symbol sequence from the encoding device 21B. Further, the transmission device 10B includes: the receiver 31 configured to receive the transmission signal sent from the transmitter; and the decoding device 32B configured to decode the symbol sequence obtained from the transmission signal received by the receiver 31, into the bit sequence to be transmitted.

As described above, the transmission device 10B includes the encoding device 21B for performing the encoding method. Similarly to Embodiment 1, this encoding method includes the encoding process of encoding the bit sequence to be transmitted, into the symbol sequence so that the symbol sequence does not include the one or more prohibited patterns. Similarly to Embodiment 1, the one or more prohibited patterns include the patterns P1 to P6.

Apparently, the symbol sequence does not include any of the patterns P1 to P6 considered as cause of degradation of waveforms caused by transmission. Therefore, the encoding method, the decoding method, the transmission method, the decoding device, the encoding device, and the transmission device, of the present embodiment can offer advantageous effect of reducing degradation of waveforms caused by transmission.

### 4. Variations

Embodiments 1 to 3 described above are just some of various embodiments of the present disclosure. Then Embodiments 1 to 3 may be modified in various ways in accordance with design or the like, as long as they can achieve the object of the present disclosure. Hereinafter, variations of Embodiments 1 to 3 are listed.

In Embodiments 1 to 3, a symbol sequence is constituted by a plurality of symbols each having a signal level to which any one of four different values is allocated. The four different values are +3 (first value), +1 (second value), -1 (third value), and -3 (fourth value) in descending order. However, the first value, the second value, the third value, and the fourth value may not be limited to the above values.

Embodiments 1 to 3 use the four level encoding techniques. However, in variations thereof, two level encoding techniques or eight or more level encoding techniques may apply. In summary, it is sufficient that a symbol sequence is constituted by a plurality of symbols each having a signal level to which any one of 2ⁿ different values is allocated and that n is equal to or lager than 1.

For example, when n is 1, a symbol sequence is constituted by a plurality of symbols each having a signal level to which any one of 2 different values (e.g., +1 and -1) is allocated. Also in this case, the one or more prohibited patterns may include one or more specific patterns which are one or more of patterns representing transition of signal levels of three or more consecutive symbols. And the one or more specific patterns may include one or more patterns in which signal levels of any two adjacent symbols of the three or more consecutive symbols are different values. Examples of the one or more prohibited patterns may include: a pattern in which a signal level transitions to have +1, -1, and +1 in this order; and a pattern in which a signal level transitions to have -1, +1, and -1 in this order.

For example, when n is 3, a symbol sequence is constituted by a plurality of symbols each having a signal level to which any one of 8 different values (e.g., +7, +5, +3, +1, -1, -3, -5, and -7) is allocated. Also in this case, the one or more prohibited patterns may include one or more specific patterns which are one or more of patterns representing transition of signal levels of three or more consecutive symbols. And the one or more specific patterns may include one or more patterns in which signal levels of any two adjacent symbols of the three or more consecutive symbols are different values. Examples of the one or more prohibited patterns may include: a pattern in which a signal level transitions to have +7, -7, and +7 in this order; and a pattern in which a signal level transitions to have -7, +7, and -7 in this order.

In other variations, the one or more prohibited patterns may not always include the patterns P1 and P2 both. In summary, the one or more prohibited patterns may include at least one of the patterns P1 and P2. The one or more prohibited patterns may not always include all of the patterns P3 to P6. In summary, the one or more prohibited patterns may include at least one of the patterns P3 to P6.

In other variations, one or more specific patterns treated as the one or more prohibited patterns may include at least one of: a pattern in which a signal level transitions to have the first value (+3), the fourth value (-3), and the second value (+1) in this order; a pattern in which a signal level transitions to have the second value (+1), the fourth value (-3), and the first value (+3) in this order; a pattern in which a signal level transitions to have the third value (-1), the first value (+3), and the fourth value (-3) in this order; and a pattern in which a signal level transitions to have the fourth value (-3), the first value (+3), and the third value (-1) in this order. In this case, degradation of waveforms caused by transmission can be more reduced.

In other variations, the one or more prohibited patterns include one or more specific patterns which are one or more of patterns representing transition of signal levels of three or more consecutive symbols. For example, the one or more prohibited patterns include one or more specific patterns which are one or more of patterns representing transition of signal levels of four consecutive symbols. Examples of the one or more prohibited patterns may include a symbol sequence of (+3, -1, -3, +3) or a symbol sequence of (-3, +3, +1, -3). For example, the one or more prohibited patterns include one or more specific patterns which are one or more of patterns representing transition of signal levels of five consecutive symbols. Examples of the one or more prohibited patterns may include a symbol sequence of (+3, -1, -3, -1, +3) or a symbol sequence of (-3, +1, +3, +1, -3).

In Embodiment, the encoding step encodes, by a predetermined conversion table, a partial bit sequence into a partial symbol sequence which is constituted by 1+p symbols and does not include the one or more prohibited patterns. In this regard, p is not limited to 1, but may be an integer equal to or larger than 1. However, increase in p may cause increase in the number of symbols included in the partial symbol sequence. Time necessary for transmitting the same partial bit sequence may increase. Accordingly, it may be preferable to decrease the encoding time period with increase in p. For example, when the encoding time period of the partial symbol sequence constituted by one symbol is represented by t1 and the encoding time period of the partial symbol sequence constituted by 1+p symbols is represented by t2, t2 may be given by a relation of t2 = t1 ^{∗} 1/(1 + p). This point may apply to the second partial symbol sequence of Embodiment 2 and the partial symbol sequence of Embodiment 3.

In Embodiments 1 to 3, m is 8 and a partial bit sequence constituted by 8 bits is obtained from a bit sequence to be transmitted. However, m is not limited to 8. It is sufficient that m is a multiple of n and may be any one of various values such as 2, 4, 16, and the like.

In Embodiment 1, not one but two partial symbol sequences are associated with a certain partial bit sequence. Not some of the partial bit sequences but all of the partial bit sequences may be treated as certain partial bit sequences. However, to associate two partial symbol sequences with all of the partial bit sequences, it is necessary to increase the number of symbols of the partial symbol sequence. Further, two partial symbol sequences associated with a certain partial bit sequence may be preferably set to that the sum of totals thereof is equal to 0. Note that, not one but two or more partial symbol sequences may be associated with a certain partial bit sequence. In this case, the sum of totals of the partial symbol sequences can be easily made to be closer to 0. This point may apply to the second partial symbol sequence of Embodiment 2 and the partial symbol sequence of Embodiment 3.

In Embodiments 1 to 3, the transmission device is used for transmitting desired data (bit sequences) from the input device (e.g., a set top box) to the output device (e.g., a display). However, the transmission device may be used as a repeater for receiving electric signals and retransmitting them. In other words, the transmission device may be configured to perform repeater operation.

In Embodiments 1 to 3, transmission data may be transmitted in a scheme which is used in an HDMI (registered trademark) interface and is referred to as transition minimized differential signaling (TDMS). This scheme is conventional and therefore details thereof are omitted.

### 5. Aspects

As apparent from the above embodiments and variations thereof, a first aspect is an encoding method including an encoding process of encoding a bit sequence to be transmitted, into a symbol sequence. The symbol sequence includes a plurality of symbols each having a signal level to which any one of 2ⁿ different values is allocated. n is an integer equal to or larger than 1. The encoding process includes encoding the bit sequence to be transmitted into the symbol sequence so that the symbol sequence does not include one or more prohibited patterns. The one or more prohibited patterns include one or more specific patterns which are one or more of patterns representing transition of signal levels of three or more consecutive symbols. The one or more specific patterns include one or more patterns in which signal levels of any two adjacent symbols of the three or more consecutive symbols are different values. Accordingly, the first aspect enables reduction of degradation of waveforms caused by transmission.

A second aspect is an encoding method which would be realized in combination with the first aspect. In the second aspect, the one or more specific patterns include one or more patterns in which increase and decrease in a signal level occur. Accordingly, the second aspect can reduce decrease in the opening of the eye pattern caused by the high frequency components, and thus reduce degradation of waveforms caused by transmission.

A third aspect is an encoding method which would be realized in combination with the first or second aspect. In the third aspect, n is equal to or larger than 2. The one or more specific patterns include one or more patterns in which a signal level is transitioned from a current value to a value which is neither a value larger than and next to the current value, nor a value smaller than and next to the current value. Accordingly, the third aspect can reduce decrease in the opening of the eye pattern caused by the high frequency components, and thus reduce degradation of waveforms caused by transmission. Further, this aspect is very effective for not only decrease in the width direction but also decrease in the height direction.

A fourth aspect is an encoding method which would be realized in combination with any one of the first to third aspects. In the fourth aspect, the one or more specific patterns include one or more patterns in which a signal level transitions between a maximum value and a minimum value. Accordingly, the fourth aspect can reduce decrease in the opening of the eye pattern caused by the high frequency components, and thus reduce degradation of waveforms caused by transmission.

A fifth aspect is an encoding method which would be realized in combination with the fourth aspect. In the fifth aspect, n is 2. The 2ⁿ different values include a first value, a second value, a third value, and a fourth value in descending order. The one or more specific patterns include at least one of: a pattern in which a signal level transitions to have the first value, the fourth value, and the first value in this order; and a pattern in which a signal level transitions to have the fourth value, the first value, and the fourth value in this order. Accordingly, the fifth aspect can reduce decrease in the opening of the eye pattern caused by the high frequency components, and thus reduce degradation of waveforms caused by transmission.

A sixth aspect is an encoding method which would be realized in combination with the fifth aspect. In the sixth aspect, the one or more specific patterns include at least one of: a pattern in which a signal level transitions to have the first value, the third value, and the first value in this order; a pattern in which a signal level transitions to have the third value, the first value, and the third value in this order; a pattern in which a signal level transitions to have the second value, the fourth value, and the second value in this order; and a pattern in which a signal level transitions to have the fourth value, the second value, and the fourth value in this order. According to the sixth aspect, it can be easy to improve DC balance. Additionally, decrease in the opening of the eye pattern, especially decrease in the height direction, also can be reduced and thus degradation of waveforms caused by transmission can be reduced.

A seventh aspect is an encoding method which would be realized in combination with the fifth or sixth aspect. In the seventh aspect, the one or more specific patterns include at least one of: a pattern in which a signal level transitions to have the first value, the fourth value, and the second value in this order; a pattern in which a signal level transitions to have the second value, the fourth value, and the first value in this order; a pattern in which a signal level transitions to have the third value, the first value, and the fourth value in this order; and a pattern in which a signal level transitions to have the fourth value, the first value, and the third value. Accordingly, the seventh aspect can reduce decrease in the opening of the eye pattern caused by the high frequency components, and thus reduce degradation of waveforms caused by transmission. Additionally, decrease in the opening of the eye pattern, especially decrease in the height direction, also can be reduced and thus degradation of waveforms caused by transmission can be reduced.

An eighth aspect is an encoding method which would be realized in combination with any one of the first to seventh aspects. In the eighth aspect, the encoding process includes an obtaining step and an encoding step. The obtaining step is a step of obtaining a partial bit sequence constituted by m bits from the bit sequence to be transmitted. The encoding step is a step of encoding the partial bit sequence into a partial symbol sequence which is constituted by 1+p symbols and does not include the one or more prohibited patterns, by use of a predetermined conversion table. m is a multiple of n. 1 is a value obtained by dividing m by n. p is an integer equal to or larger than 1. According to the eighth aspect, the partial bit sequence is converted into the partial symbol sequence directly by use of the predetermined conversion table. Therefore, the encoding process can be facilitated.

A ninth aspect is an encoding method which would be realized in combination with any one of the first to seventh aspects. In the ninth aspect, the encoding process includes an obtaining step, an encoding step, and a converting step. The obtaining step is a step of obtaining a partial bit sequence constituted by m bits from the bit sequence to be transmitted. The encoding step is a step of encoding the partial bit sequence into a first partial symbol sequence constituted by 1 symbols so that each of signal levels of the 2ⁿ different values represents a combination of n bits. The converting step is a step of converting the first partial symbol sequence into a second partial symbol sequence which is constituted by 1+p symbols and does not include the one or more prohibited patterns, by use of a predetermined conversion table. m is a multiple of n. 1 is a value obtained by dividing m by n. p is an integer equal to or larger than 1. According to the ninth aspect, addition of the converting step can convert the encoding method of the general four level pulse amplitude modulation into the encoding method of the present aspect.

A tenth aspect is an encoding method which would be realized in combination with any one of the first to seventh aspects. In the tenth aspect, the encoding process includes an obtaining step, a converting step, and an encoding step. The obtaining step is a step of obtaining a first partial bit sequence constituted by m bits from the bit sequence to be transmitted. The converting step is a step of converting the first partial bit sequence into a second partial bit sequence constituted by m+q bits, by a predetermined conversion procedure. The encoding step is a step of encoding the second partial bit sequence into a second partial symbol sequence which is constituted by k symbols and does not include the one or more prohibited pattern, by use of a predetermined conversion table. m is a multiple of n. q is a multiple of n. k is a value obtained by dividing a sum of m and q by n. According to the tenth aspect, even when the conversion procedure for bit sequences by a general encoding method for two level transmission is used as the conversion procedure in the converting step, a bit sequence can be converted into the partial symbol sequence encoded by the encoding method of the present aspect.

An eleventh aspect is a decoding method including decoding a symbol sequence into a bit sequence to be transmitted, by a decoding process corresponding to the encoding process of the encoding method according to any one of the first to tenth aspects. Accordingly, the eleventh aspect enables reduction of degradation of waveforms caused by transmission.

A twelfth aspect is a transmission method including: encoding a bit sequence to be transmitted, into a symbol sequence by the encoding process of the encoding method according to any one of the first to tenth aspects; and sending a transmission signal representing the symbol sequence. The transmission method further includes: receiving the transmission signal sent; and decoding the symbol sequence obtained from the transmission signal received, into the bit sequence to be transmitted, by the decoding process of the decoding method according to the eleventh aspect. Accordingly, the twelfth aspect enables reduction of degradation of waveforms caused by transmission.

A thirteenth aspect is an encoding device (21; 21A; 21B) configured to perform an encoding process of encoding a bit sequence to be transmitted, into a symbol sequence. The symbol sequence includes a plurality of symbols each having a signal level to which any one of 2ⁿ different values is allocated. n is an integer equal to or larger than 1. The encoding process includes encoding the bit sequence to be transmitted into the symbol sequence so that the symbol sequence does not include one or more prohibited patterns. The one or more prohibited patterns include one or more specific patterns which are one or more of patterns representing transition of signal levels of three or more consecutive symbols. The one or more specific patterns include one or more patterns in which signal levels of any two adjacent symbols of the three or more consecutive symbols are different values. Accordingly, the thirteenth aspect enables reduction of degradation of waveforms caused by transmission.

A fourteenth aspect is a decoding device (32; 32A; 32B) configured to decode a symbol sequence into a bit sequence to be transmitted, by a decoding process corresponding to the encoding process of the encoding device (21; 21A; 21B) according the thirteenth aspect. Accordingly, the fourteenth aspect enables reduction of degradation of waveforms caused by transmission.

A fifteenth aspect is a transmission device (10; 10A; 10B) including: the encoding device (21; 21A; 21B) according to thirteenth aspect; a transmitter (22); a receiver (31); and the decoding device (32; 32A; 32B) according to the fourteenth aspect. The encoding device (21; 21A; 21B) is configured to encode a bit sequence to be transmitted, into a symbol sequence. The transmitter (22) is configured to send a transmission signal representing the symbol sequence from the encoding device (21; 21A; 21B). The receiver (31) is configured to receive the transmission signal sent from the transmitter (22). The decoding device (32; 32A; 32B) is configured to decode the symbol sequence obtained from the transmission signal received by the receiver (31), into the bit sequence to be transmitted. Accordingly, the fifteenth aspect enables reduction of degradation of waveforms caused by transmission.

A sixteenth aspect is a transmission device (10; 10A; 10B) realized in combination with the fifteenth aspect. In the sixteenth aspect, the transmitter (22) and the receiver (31) are configured to communicate with each other by an optical transmission scheme. Accordingly, the sixteenth aspect can increase a transmission speed (rate).

### Reference Signs List

- 10, 10A, 10B: Transmission Device
- 21, 21A, 21B: Encoding Device
- 22: Transmitter
- 31: Receiver
- 32, 32A, 32B: Decoding Device

## Claims

1. An encoding method comprising an encoding process of encoding a bit sequence to be transmitted, into a symbol sequence,
the symbol sequence including a plurality of symbols each having a signal level to which any one of 2ⁿ different values is allocated,
n being an integer equal to or larger than 1,
the encoding process including encoding the bit sequence to be transmitted into the symbol sequence so that the symbol sequence does not include one or more prohibited patterns,
the one or more prohibited patterns including one or more specific patterns which are one or more of patterns representing transition of signal levels of three or more consecutive symbols, and
the one or more specific patterns including one or more patterns in which signal levels of any two adjacent symbols of the three or more consecutive symbols are different values.

2. The encoding method according to claim 1, wherein
the one or more specific patterns include one or more patterns in which increase and decrease in a signal level occur.

3. The encoding method according to claim 1 or 2, wherein:
n is equal to or larger than 2; and
the one or more specific patterns include one or more patterns in which a signal level is transitioned from a current value to a value which is neither a value larger than and next to the current value, nor a value smaller than and next to the current value.

4. The encoding method according to any one of claims 1 to 3, wherein
the one or more specific patterns include one or more patterns in which a signal level transitions between a maximum value and a minimum value.

5. The encoding method according to claim 4, wherein:
n is 2;
the 2ⁿ different values include a first value, a second value, a third value, and a fourth value in descending order; and
the one or more specific patterns include at least one of
a pattern in which a signal level transitions to have the first value, the fourth value, and the first value in this order, and
a pattern in which a signal level transitions to have the fourth value, the first value, and the fourth value in this order.

6. The encoding method according to claim 5, wherein
the one or more specific patterns include at least one of
a pattern in which a signal level transitions to have the first value, the third value, and the first value in this order,
a pattern in which a signal level transitions to have the third value, the first value, and the third value in this order,
a pattern in which a signal level transitions to have the second value, the fourth value, and the second value in this order, and
a pattern in which a signal level transitions to have the fourth value, the second value, and the fourth value in this order.

7. The encoding method according to claim 5 or 6, wherein
the one or more specific patterns include at least one of
a pattern in which a signal level transitions to have the first value, the fourth value, and the second value in this order,
a pattern in which a signal level transitions to have the second value, the fourth value, and the first value in this order,
a pattern in which a signal level transitions to have the third value, the first value, and the fourth value in this order, and
a pattern in which a signal level transitions to have the fourth value, the first value, and the third value.

8. The encoding method according to any one of claims 1 to 7, wherein:
the encoding process includes
an obtaining step of obtaining a partial bit sequence constituted by m bits from the bit sequence to be transmitted, and
an encoding step of encoding the partial bit sequence into a partial symbol sequence which is constituted by 1+p symbols and does not include the one or more prohibited patterns, by use of a predetermined conversion table;
m is a multiple of n;
1 is a value obtained by dividing m by n; and
p is an integer equal to or larger than 1.

9. The encoding method according to any one of claims 1 to 7, wherein:
the encoding process includes
an obtaining step of obtaining a partial bit sequence constituted by m bits from the bit sequence to be transmitted,
an encoding step of encoding the partial bit sequence into a first partial symbol sequence constituted by 1 symbols so that each of signal levels of the 2ⁿ different values represents a combination of n bits, and
a converting step of converting the first partial symbol sequence into a second partial symbol sequence which is constituted by 1+p symbols and does not include the one or more prohibited patterns, by use of a predetermined conversion table;
m is a multiple of n;
1 is a value obtained by dividing m by n; and
p is an integer equal to or larger than 1.

10. The encoding method according to any one of claims 1 to 7, wherein:
the encoding process includes
an obtaining step of obtaining a first partial bit sequence constituted by m bits from the bit sequence to be transmitted,
a converting step of converting the first partial bit sequence into a second partial bit sequence constituted by m+q bits, by a predetermined conversion procedure, and
an encoding step of encoding the second partial bit sequence into a second partial symbol sequence which is constituted by k symbols and does not include the one or more prohibited pattern, by use of a predetermined conversion table;
m is a multiple of n;
q is a multiple of n; and
k is a value obtained by dividing a sum of m and q by n.

11. A decoding method comprising decoding a symbol sequence into a bit sequence to be transmitted, by a decoding process corresponding to the encoding process of the encoding method according to any one of claims 1 to 10.

12. A transmission method comprising:
encoding a bit sequence to be transmitted, into a symbol sequence by the encoding process of the encoding method according to any one of claims 1 to 10;
sending a transmission signal representing the symbol sequence;
receiving the transmission signal sent; and
decoding the symbol sequence obtained from the transmission signal received, into the bit sequence to be transmitted, by the decoding process of the decoding method according to claim 11.

13. An encoding device configured to perform an encoding process of encoding a bit sequence to be transmitted, into a symbol sequence,
the symbol sequence including a plurality of symbols each having a signal level to which any one of 2ⁿ different values is allocated,
n being an integer equal to or larger than 1,
the encoding process including encoding the bit sequence to be transmitted into the symbol sequence so that the symbol sequence does not include one or more prohibited patterns,
the one or more prohibited patterns including one or more specific patterns which are one or more of patterns representing transition of signal levels of three or more consecutive symbols, and
the one or more specific patterns including one or more patterns in which signal levels of any two adjacent symbols of the three or more consecutive symbols are different values.

14. A decoding device configured to decode a symbol sequence into a bit sequence to be transmitted, by a decoding process corresponding to the encoding process of the encoding device according to claim 13.

15. A transmission device comprising:
the encoding device according to claim 13, for decoding a bit sequence to be transmitted, into a symbol sequence;
a transmitter configured to send a transmission signal representing the symbol sequence from the encoding device;
a receiver configured to receive the transmission signal sent from the transmitter; and
the decoding device according to claim 14, for decoding the symbol sequence obtained from the transmission signal received by the receiver, into the bit sequence to be transmitted.
